Europäisches Patentamt

European Patent Office

Office européen des brevets

(11) Publication number: **0 612 862 A1**

# EUROPEAN PATENT APPLICATION

(21) Application number: 94300497.8

(22) Date of filing: 24.01.94

(51) Int. Cl.5: **C23C 16/52**, G01J 5/00

(30) Priority: 24.02.93 US 21840

(43) Date of publication of application:
31.08.94 Bulletin 94/35

(84) Designated Contracting States:
**DE FR GB IT NL**

(71) Applicant: **APPLIED MATERIALS, INC.**
**3050 Bowers Avenue**
**Santa Clara California 95054-3299 (US)**

(72) Inventor: **Gronet, Christian M.**
**12 Violet Avenue**
**San Carlos, CA 94070 (US)**
Inventor: **Miner, Gary E.**
**4974 Hildasue Terrace**
**Fremont, CA 94555 (US)**

(74) Representative: **Bayliss, Geoffrey Cyril et al**
**BOULT, WADE & TENNANT**
**27 Furnival Street**
**London EC4A 1PO (GB)**

(54) **Measuring wafer temperatures.**

(57) The disclosure relates to a semi-conductor processing apparatus (20) having a processing chamber (21) for a wafer (22) including a heating element (15) located directly above the wafer. An apparatus is provided for measuring the temperature of the wafer (22) which is insenstive to the emissivity of the surface of the wafer comprising a reflector (30) which is placed near to the surface of the wafer to form a reflecting cavity (32) between the surface and the reflector such that any thermal radiation emitted from the surface of the wafer is repeatedly reflected between the reflector and the surface. A light pipe (36) inserted through the reflector removes a sample of the radiation within the reflecting cavity to a pyrometer (38) which determines the temperature of the wafer. The measured temperature may be used by a controller (16) to control the amount of radiant heat applied to the wafer by the heating element (15) located directly above the wafer.

FIG. 3

FIG. 2

HEATING ELEMENT

15 26 28

37 21 39 32 34' 34 24 37

30 30 30

25 33 31 36' 31 35 36 33 25

20 41

**38**
**PYROMETER** 35

35

**16**
**CONTROLLER**

19 CONDUIT POSITION
18 WAFER ROTATION
17 HEAT DISTRIBUTION
AND INTENSITY

Background of the Invention

The invention relates to a method of measuring the temperature of a semiconductor wafer in a wafer processing chamber.

In many manufacturing processes, e.g., semiconductor wafer processes, high quality results can be achieved only when the temperature of the workpiece (e.g., the wafer) is tightly controlled. However, in many circumstances the temperature measurement must be made without physically contacting the workpiece. For example, a wafer being processed would be contaminated if contacted by a thermal probe. Thus, there is a need for a method for measuring temperature without contacting the workpiece.

One known method for non-contact temperature measurement is based on measurements of thermal radiation. Every body at a temperature greater than absolute zero emits broadband thermal radiation. At temperatures below about 500°C, most of the radiation is infrared, whereas at higher temperatures, some visible light is emitted.

The rate of emission of radiation per unit area, integrated over the entire spectrum of wavelengths, increases as the temperature of the surface increases. The relationship between emission and temperature at a given wavelength is represented by the Stefan-Boltzmann equation:

$$I_{T,\lambda} = \sigma \bullet e(\lambda) \bullet T^4, \qquad (1)$$

where $I_{T,\lambda}$ is the total radiation emitted at wavelength $\lambda$ per second per $cm^2$ from a surface at absolute temperature $T$; $e(\lambda)$ is a constant called the emissivity which ranges from 0 to 1 as a function of wavelength $\lambda$ depending on the nature of the emitting surface; and $\sigma = 0.0567 \times 10^{-4}$ erg-$cm^{-2}$-$deg^{-4}$-$sec^{-1}$ (the Stefan-Boltzmann constant). A more detailed explanation of the Stefan-Boltzmann equation can be found in texts such as: Heat and Thermodynamics; Zemansky, M.W.; McGraw Hill and Fundamentals of Modern Physics; Eisberg R.M.; John Wiley and Sons.

If the emissivity of the workpiece is known at a given wavelength or range of wavelengths, the Stefan-Boltzmann relation may be used to measure the workpiece temperature by collecting light emitted by the workpiece at those wavelengths (and no other light) and measuring the intensity of this light in a detector such as a pyrometer or radiometer.

Unfortunately, the emissivity of the workpiece is often unknown. For example, it has been found that the emissivity of silicon wafers varies widely from wafer to wafer, thereby requiring that the emissivity of each wafer be separately measured in order to use the above technique to measure wafer temperatures. Furthermore, it has been found that the emissivity of a wafer which has been raised to a high temperature in a wafer fabrication process is different from the emissivity of the wafer measured at room temperature. As a result, the emissivity measurements must be made in process, enhancing the difficulty of using the above technique to measure wafer temperatures.

U.S. Patent 4,823,291 (Berman) describes an apparatus which measures the temperature of silicon wafers by computing the emissivity $e_W$ of the wafer while it is being processed. The wafer is illuminated with a light source so that the amount of light energy transmitted through and reflected from the wafer can be separately measured. The transmittance of the wafer $t_W$ (i.e., the fraction of the incident light energy which is transmitted through the wafer, either directly or in diffused form) and the reflectance of the wafer $r_W$ (i.e., the fraction of the incident light energy which is reflected from the wafer, either directly or in diffused form) are computed and used to derive the absorptivity $a_W$ of the wafer (i.e., the fraction of the incident light energy which is absorbed by the wafer) from the conservation of energy equation

$$t_W + r_W + a_W = 1 \qquad (2)$$

Then, the emissivity $e_W$ is obtained by Kirchoff's law of thermodynamics, which provides that

$$\frac{e_W}{a_W} = 1 \qquad\qquad (3)$$

A disadvantage of this approach is that it requires complex apparatus including multiple light detectors, a beam splitter, a light source and light focussing system, and a control loop for monitoring the output of the light source. A further disadvantage is that, for proper operation, the surface of the wafer must be a specular reflector; that is, it must reflect incident light such that the angle of reflection is equal to the angle of incidence. Typical wafer surfaces are diffusely reflecting; however, if a diffusely reflecting wafer is used, the reflected light will scatter throughout the process chamber, making it difficult to design the process chamber to both collect the reflected light and permit processing of the wafer.

U.S. Patent 4,533,243 (Zhukov, et al) describes a method of measuring temperature of a liquid metal. A light pipe with a bulbous end is placed in contact with the molten metal. Thermal radiation from the molten metal passes into the bulbous end and down the light pipe where it is measured by a pyrometer.

A disadvantage of this method is that the light pipe must be brought into contact with the molten metal, making this method unacceptable for non-contact applications such as semiconductor processing.

Thus, there remains a need for a simple non-contact method for measuring the temperature of a workpiece at multiple locations.

## Summary of the Invention

In one aspect, the invention features an apparatus and method for measuring the temperature of a surface of a body. A reflector is placed near to the body to form a reflecting cavity between the body and the reflector, so that thermal radiation emitted from the surface of the body is reflected back onto the body. Because all thermal radiation emitted from the body is reflected back onto the body, the intensity of the thermal radiation within the reflecting cavity is not a function of the emissivity of the surface of the body. As a result, a radiation sensor sampling the thermal radiation within the reflecting cavity can determine the temperature of the body more accurately than previously possible.

The above apparatus and method may be used in many applications, but is described below in connection with measuring the temperature of a semiconductor wafer in semiconductor processing chamber. In this and other preferred embodiments, the reflector does not contact the surface of the body, and the topography of the reflector is locally parallel with the surface of the body (e.g., both are flat), so that thermal radiation emitted by the body is repeatedly reflected between the body and the reflector. This goal is also promoted by choosing a reflector which is at least twenty times wider than the distance between the reflector and the body.

In applications where the body is at elevated temperature, it may be useful to cool the reflector to a temperature substantially below the temperature of said body, so as to prevent the elevated temperature from affecting the reflectivity of the reflector.

In semiconductor processing and other applications, it is also useful to use a light conductive conduit (e.g., inserted into the reflecting cavity through a small hole in the reflector) to collect thermal radiation from the reflective cavity and carry the collected thermal radiation to a remote pyrometer. The conduit may be coupled to an actuator to move it relative to the body to measure the temperature at various locations on the body. The conduit may be an optical fiber or crystal, an open tube with reflective internal surfaces, or a system of mirrors and lenses.

In a semiconductor processing embodiment, the above apparatus can be used with a feedback loop to control the temperature of a wafer at various points along the surface of the wafer. This embodiment uses a heating element to independently heat different areas of the wafer, for example, a heating element having a plurality of controllable radiant energy sources (each source irradiating a portion of the surface area of the wafer). A controller individually controls the intensity of irradiation from each radiant energy source in response to the amount of thermal radiation sensed at corresponding positions on the wafer.

## Brief Description of the Drawing

Fig. 1A is a section of a parallel plate cavity illustrating the principle of the invention.

Fig. 1B is a section of a generalized cavity illustrating the principle of the invention.

Fig. 2 is a partial section of the interior of a semiconductor processing chamber illustrating the invention;

Fig. 3 is an enlarged portion of the chamber in Fig. 2 showing parts of the wafer and reflector illustrating the reflection of thermal radiation within in the cavity between the wafer 22 and reflector 30; and

Fig. 4 is a plot of the spectral radiance versus wavelength on a logarithmic scale for a body with absorptivity $\underline{a} = 1$ and emissivity $\underline{e} = 1$ (i.e., a "black body") at several different temperatures.

## Description of the Preferred Embodiment(s)

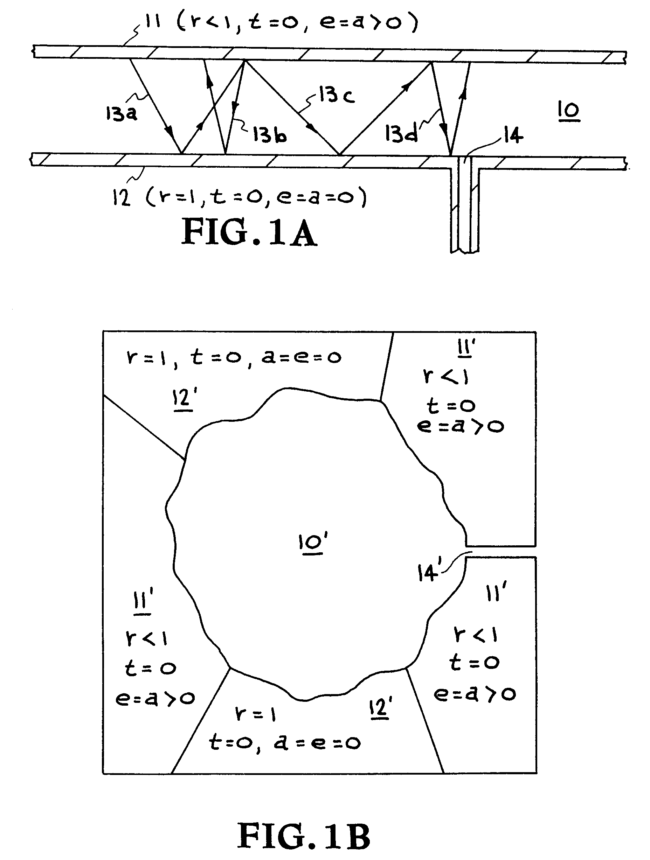

To illustrate the principle of operation of the invention, it is useful to consider the radiation patterns in a cavity such as illustrated in Fig. 1A. The walls of the cavity 10 are modeled as infinite and parallel. Upper wall 11 has a transmissivity $\underline{t} = 0$, emissivity $\underline{e}$ and absorptivity $\underline{a}$. Lower wall 12 has a reflectivity $\underline{r} = 1$, and

zero transmissivity, emissivity and absorptivity.

Thermal radiation is emitted by upper wall 11 of cavity 10 in a random pattern; the radiation reflects from lower wall 12, and then is partially reflected and partially absorbed by upper wall 11. The portion reflected from upper wall 11 is then again reflected from lower wall 12 and then partially reflected and partially absorbed by upper wall 11. This pattern is illustrated by the exemplary light rays which are partially traced in Fig. 1A.

For the purposes of this example, assume that upper wall 11 is a diffuse reflector, that is, incident light is reflected at different angles and different intensities, and that upper wall 11 is at a uniform temperature T. Also, assume that lower wall 12 is a specular reflector. (Note that it is not necessary that either wall be a diffuse or specular reflector; simply that lower wall 12 have a reflectance of 1 and that both walls have a transmittance of 0.)

Because light is emitted by upper wall 11 in a random pattern, and reflected throughout cavity 10 in an equally random (isotropic) pattern, over a given period of time approximately an equal amount of light reflects at a given point on lower wall 12. The light reflecting at a given location on lower wall 12, e.g. at 14, can be separated into several categories: light which has not yet partially reflected from upper wall 11 (0-reflection light such as 13a); light which has partially reflected once from upper wall 11 (1-reflection light such as 13b and 13c), light which has partially reflected twice from upper wall 11 (2-reflection light such as 13d), and so on. Because of the random distribution of light in the cavity 10, each category of light will irradiate lower wall 12 with a uniform spacial distribution, therefore, the total light incident at a given point on lower wall 12 will include light from each category.

Each time light reflects from upper wall 11, a portion of the light is absorbed by upper wall 11. The remaining light is reflected from upper wall 11; the energy of the reflected light is reduced by the factor $1-a$. Thus, if the 0-reflection light incident on upper wall 11 at a wavelength $\lambda$ has an intensity equal to $\sigma e(\lambda)T^4$ (due to Stefan-Boltzmann equation), the 1-reflection light has an intensity equal to $\sigma e(\lambda)T^4(1-a)$, the 2-reflection light has an intensity equal to $\sigma e(\lambda)T_4(1-a)^2$, and so on. Thus, $I_T$, the total intensity of the light incident at a given location on lower wall 12, is equal to an infinite series:

$$I_{T,\lambda} = \sigma e(\lambda)T^4 + \sigma e(\lambda)T^4(1-a) + \sigma e(\lambda)T^4(1-a)^2 + \ldots = \sigma e(\lambda)T^4\left[\sum_{n=0}^{\infty}(1-a)^n\right] \qquad (4)$$

This infinite series can be summed:

$$I_T = \sigma e(\lambda)T^4\left[\frac{1}{a}\right] \qquad (5)$$

But by Kirchoff's law, $e = a$. Substituting, this gives:

$$I_T = \sigma e(\lambda)T^4\left[\frac{1}{a(\lambda)}\right] = \sigma e(\lambda)T^4\left[\frac{1}{e(\lambda)}\right] = \sigma T^4 \qquad (6)$$

Thus, the total light intensity at a wavelength $\lambda$ incident upon any point along the lower wall 12 is proportional to $T^4$, with the proportionality being independent of the emissivity $e$ of the cavity walls. Viewed another way, the total light intensity within cavity 10 is the same as it would be if upper wall 11 were a "black body", i.e., the emissivity $e$ of upper wall 11 were 1: if $e_{wall} = 1$ (and therefore $a_{wall} = 1$ by Kirchoff's law) the first term of the infinite series of equation (4) would be $\sigma T^4$, and the remaining terms of equation (4) would be zero because there would be no 1-reflection light (or other n-reflection light) since $a_{wall} = 1$ and thus all light impinging on upper wall 11 would be absorbed.

It should be noted that the first few terms of the infinite series of equation (4) are the dominant terms (as with most infinite series which can be summed); furthermore, these first few terms correspond to the 0-reflection, 1-reflection, 2-reflection, etc. light, which predominantly originates from nearby areas on upper wall 11. As a result, the value of the infinite series of equation (4) is largely determined by the temperature of areas of the upper wall 11 which are near to the point at which thermal radiation is being sampled.

Thus, it is not necessary to assume that the temperature of upper wall 11 is spatially uniform. Even if the temperature of upper wall 11 spatially varies (as long as the variation is relatively slow and continuous), the series of equation (4) will still be substantially equal to the summation of equation (5), and, as a result, the radiation measured at a given location in the cavity 10 will still be independent of the emissivity of upper wall 11.

Furthermore, if it is assumed that the temperature of upper wall 11 spatially varies, by sampling the light at any location in the cavity 10 (e.g., by an optical fiber entering cavity 10 through aperture 14), the temperature of upper wall 11 in the area near to the sampling point can be determined independently of the emissivity of upper wall 11.

It may also be noted that, at a given location on the lower wall 12, 0-reflection, 1-reflection, and 2-reflection light which originated at nearby points on upper wall 11 is more likely to arrive at angles nearly perpendicular to the plane of the walls; conversely, light which originated at distant points on upper wall 11 is more likely to arrive at angles far from the perpendicular. (This observation is clearly true of 0-reflection light, and true, to a lesser extent, of 1-reflection and 2-reflection light, although the correlation between distance of origin and angle of incidence decreases rapidly with the number of reflections.)

Given the observation of the preceding paragraph, it is apparent that one may further localize a temperature measurement (taken, e.g., by collecting light at aperture 14) by discarding light which arrives at angles far from the perpendicular. Thus by selecting a radiation sensor with a narrow or wide reception angle, temperature measurements can be made more or less localized, respectively.

Furthermore, in applications where the emissivity and absorptivity are relatively high, e.g., 0.7 or more, it may be possible to further localize the temperature measurement by collecting radiation from a location nearer to upper wall 11. This is because, when the emissivity and absorptivity are relatively high, equation 4 is dominated by the first term which corresponds to 0-reflection light. In these situations, if the radiation sensor is placed closer to upper wall 11, it will collect only local 0-reflection radiation (0-reflection light from distant locations will enter the sensor at angles beyond the sensor's reception angle), and therefore the resulting temperature measurement will be more localized.

Finally, it should be noted that lower wall 12 need only be reflecting at the wavelengths at which thermal radiation will be sampled; the reflectivity at other wavelengths is less crucial. This is true because the terms of the infinite series of equation (4) model the intensity of light at one wavelength ($\lambda$); the intensity at other wavelengths is not relevant to the series nor does it affect the summation of equations (5) and (6). Although some thermal radiation which is incident on upper wall 11 at wavelength $\lambda$ will be absorbed and later re-emitted as radiation at a different wavelength, this effect is not relevant to equation (4) because equation (4) does not account for radiation <u>absorbed</u> by upper wall 11; rather, it accounts for the radiation <u>reflected</u> by upper wall 11, and the reflected radiation will be at the same wavelength $\lambda$ as the incident radiation.

The reasoning applied above is not limited to cavities between infinite parallel plates such as illustrated in Fig. 1A. The same reasoning may be applied to any cavity (of finite or infinite size) with walls that have (a) locally uniform temperature and emissivity greater than zero or (b) unit reflectivity, as long as the physical geometry of the cavity operates to randomly (isotropically) distribute thermal radiation generated by the cavity walls throughout the cavity. One such cavity 10' is illustrated in Fig. 1B. The walls of the cavity include regions 12' that have unit reflectivity and zero emissivity, transmissivity, and absorptivity, and regions 11' that have zero transmissivity but non-zero reflectivity, emissivity, and absorptivity. If each of the regions 11' has the same temperature and emissivity, and if the geometry randomly (isotropically) reflects and distributes thermal radiation throughout the cavity 10', then each point on the walls of cavity 10' will be illuminated with an equal amount of 1-reflection, 2-reflection, 3-reflection, etc. light. As a result, the light incident, e.g., at aperture 14', will be equal to the infinite series of equation (4), and therefore the light incident at aperture 14 will be dependent on the temperature of the inner surfaces of regions 11' but independent of the emissivity of the material which comprises regions 11'.

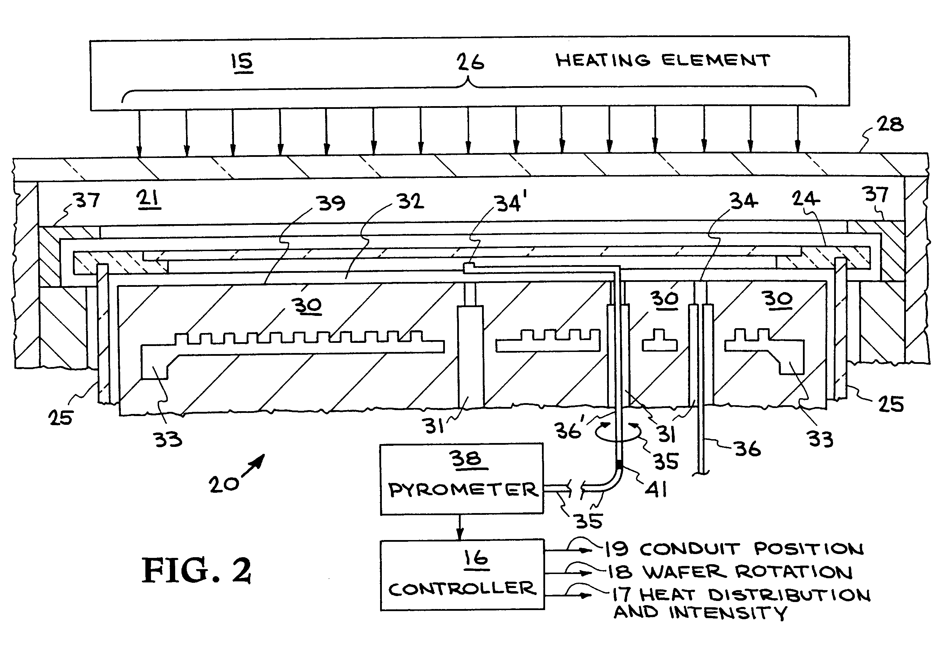

The preceding principles may be used to create a non-contact temperature measurement apparatus which is independent of emissivity. For example, a cavity of the type described with reference to Fig. 1A can be used to measure the temperature of a semiconductor wafer. A semiconductor processing chamber utilizing this principle is illustrated in Fig. 2.

The semiconductor processing apparatus of Fig. 2, generally indicated as 20, comprises a cylindrical processing chamber 21 (shown in cross-section) in which, e.g., a disk-shaped, eight inch (200 mm) diameter wafer 22 is mounted. The wafer 22 is heated by a heating element 15 located directly above the wafer. The heating element 15 generates radiant energy light 26 which enters the processing chamber 21 after passing through a quartz window 28 which is approximately one inch (2.5 cm) above the wafer. A suitable heating element 15 is disclosed in U.S. Patent 5,155,336, which is assigned to the assignee of the present application. The heating element disclosed therein uses 187 light pipes to collect and collimate light and direct the collimated light into the processing chamber 21. The 187 light pipes are divided into twelve groups which are located in a radially symmetrical manner. The groups can be individually adjusted so as to control the intensity of light falling on different areas of the wafer 22 below.

A water cooled reflector 30 is located beneath the wafer 22, so as to form a reflecting cavity 32 between the wafer 22 and the reflector 30. Thermal radiation emitted by the wafer 22 is reflected in this cavity 32, producing an ambient radiation level. Just as for the cavity 10 of Fig. 1, the radiation level within cavity 32 will be a function of the temperature of the wafer but independent of the emissivity of the wafer 22 and of the temperature of the reflector.

The reflecting surface 39 of the reflector 30 is made of a highly polished stable reflective surface. As the reflectivity of surface 39 approaches 100%, the behavior of the cavity 32 more closely approximates the ideal model of Fig. 1A. The most reflective known surface is gold. Thus, in one embodiment, the reflective surface is a gold foil sealed within a quartz plate. However, using gold in a semiconductor processing chamber may increase, or appear to increase, contamination risks. Nickel is more inert than gold and has a slightly higher reflectivity than stainless steel, therefore nickel plated stainless steel is currently preferred. However, at given wavelengths, a surface other than gold, nickel, or stainless steel may have the highest reflectivity.

Experimental models have shown that the cavity 10 of Fig. 1A becomes a more accurate model for the cavity 32 of Fig. 2 when the width-to-height ratio of cavity 32 is increased. Thus, to bring cavity 32 closer to the ideal model of Fig. 1A, it is desirable to minimize the distance between the wafer 22 and the reflector 30. In the embodiment illustrated in Fig. 2, the wafer has a diameter of eight inches, and the distance between the wafer and reflector is approximately .3 inches (7.6 mm), thus the width-to-height ratio of the cavity 32 is 8/.3 or 27. (The distance between the wafer 22 and reflector 30 may be larger, e.g., .35 inches (8.9 mm), in the "bent conduit" embodiment described below, and smaller, e.g., .25 inches (6.4 mm), in the "straight conduit" embodiment described below). In any case, a width-to-height ratio of at least 20 is preferred.

To measure the temperature of the wafer 22, some of the ambient radiation in cavity 32 is captured in the open end 34 of a rigid conduit 36, and communicated to the opposite end of the conduit, where the radiation is coupled to flexible light pipe 35 (i.e., an optical fiber), which carries the thermal radiation for approximately 10 feet (3 m) to a radiation sensitive pyrometer 38. Pyrometer 38 determines the amount of thermal radiation received and thereby determines the temperature of the portion of the wafer adjacent to the open end 34 of the conduit. As described below, the wafer may be rotated about its axis to place different portions of the wafer above open end 34.

There are two possible embodiments of the conduit, both of which are shown in Fig. 2.

In the first embodiment, the conduit is straight, as indicated at 36', and is placed at a fixed position in the reflector 30. The open end 34 of the straight conduit is positioned substantially flush with the surface of the reflector 30. In this embodiment, the reception angle of the conduit is relatively wide, e.g., 52° (measured empirically). As a result, the pyrometer reads the temperature of a relatively large area of the underside of the wafer 22. If it is desirable to measure a smaller area of the wafer, a conduit with a smaller reception angle can be used, or (if conditions warrant, as discussed above) the conduit can be moved closer to the underside of the wafer. However, either of these approaches would also reduce the signal level and therefore the signal-to-noise ratio at the detector.

In alternative embodiments, a plurality of straight conduits protrude into the reflecting cavity 32, with each conduit sampling the thermal radiation from a different location on the underside of the wafer 22. Preferably, these conduits would have a narrower reception angle than a single conduit, to localize the measurements of each conduit. Each of the samples of radiation can then be removed to individual, dedicated pyrometers which measure the temperature of the area of the wafer to which these pyrometers are individually assigned. From this data, a temperature profile of radial bands of the wafer can be calculated by rotating the wafer. For the sake of example, three apertures 31 which can receive conduits are shown in Fig. 2. Experimental data indicates that, as long as there are relatively few conduits and apertures, and cross-sectional area of each conduit and aperture is relatively small, the small amount of thermal radiation which is lost (i.e., not reflected) in the one conduit or aperture does not substantially adversely affect the validity of the temperature measurements taken by other conduits.

It is also possible to mount a single conduit 36 such that it can be moved laterally between the edge and center of the wafer. Here as well, the conduit could have a narrower reception angle than a fixed single conduit. As the conduit moves along this path, radiant energy is continually sampled and processed to determine the temperature of the specific area generally above the end 34 of the conduit 36 at the time of sampling. This measured temperature is then correlated with the position at which it was measured and a temperature profile of a radial band of the wafer can be plotted by rotating the wafer. To allow the conduit 36 to move along this path, a slot (not illustrated) is formed in the body of the water cooled reflector 30. This slot acts as a guide for the conduit 36. With suitable instrumentation attached to the conduit 36, the exact location of its end 34, at any specific time, can be determined and when correlated with the rotational position of the wafer 22 at that time can be equated to a specific position on the underside of the wafer.

In an alternative embodiment, the conduit 36' has a bent shape, with two vertical ends joined by a horizontal middle section. The conduit 36' is coupled to an actuator (not shown) which rotates the conduit through a 360° arc in the directions indicated by arrow 35. (The flexible light pipe 35 - which is rigidly attached to the conduit 36' - has sufficient elasticity to twist 180° in either direction as the conduit 36' rotates through this 360° arc.) In this embodiment, the open end 34' is positioned relatively close (e.g., four one-hundredths of an inch) to the lower surface of the wafer 22, thus minimizing the distance between the wafer 22 and the reflector 30.

The conduit 36 is preferably made of a heat tolerant and corrosion resistant material, such as a single sapphire crystal. Although a sapphire conduit has been used successfully, it will be apparent that any form of optical fiber, or even a open pipe with reflective internal surfaces, can also be used effectively to communicate thermal radiation from cavity 32 to pyrometer 38. Another alternative is to use an optical system comprising a small-radius objective lens mounted in the reflector 30 and a system of mirrors and lenses which communicate radiation collected by the lens (possibly via an optical fiber) to the pyrometer. These alternative embodiments may be less expensive than sapphire conduits if off-the-shelf optical elements with the appropriate size and optical characteristics can be found.

The light pipe 35 may comprise, for example, semi-flexible quartz fiber encased in a reflective coating. It is coupled to the conduit by a commercially available fiber coupler 41 which holds the ends of the conduit and light pipe at precisely controlled positions in contact or near-contact with each other. If there is a gap between the end of the conduit and the light pipe, it may affect the reception angle of the conduit, because light entering the conduit at extreme angles will also exit the conduit (after reflecting within the conduit) at extreme angles and therefore may fail to couple into the light pipe. Thus the reception angle of the conduit can be adjusted by choosing a coupler 41 which positions the conduit and light pipe at an appropriate distance apart from each other.

Suitable quartz fiber light pipes, sapphire crystal conduits, and light pipe/conduit couplers may be obtained from the Luxtron Corporation-Accufiber Division, 9550 S.W. Nimbus Avenue, Beaverton, OR 97005.

Wafer 22 is supported at its edges by a guard ring 24 having a radial width of approximately one inch (2.5 cm). To minimize contamination of the wafer 22, the guard ring 24 is manufactured of silicon. The guard ring rests on a rotatable tubular cylinder 25 which is coupled to an actuator (not shown) which rotates the cylinder 25 and thereby rotates the guard ring 24 and wafer 22. Cylinder 25 is preferably manufactured of a relatively heat tolerant and relatively inert substance such as quartz.

In semiconductor wafer processing, it is important for the wafer to have a controlled temperature profile across its surface. As has been described previously, the heating element 15 can control the intensity of light 26 from groups of light pipes which illuminate certain areas of the upper surface of the wafer 22. The control of these radiant energy sources therefore serves to control and determine the temperature profile on the wafer 22.

To determine the temperature profile of the wafer 22, a controller 16 controls the wafer actuator (via line 18) and/or the conduit actuator (via line 19) to take temperature measurements at a number of different locations on the lower surface of the wafer 22. By rotating the wafer, the temperature of various locations on the wafer may be measured. In the straight conduit embodiment, by rotating the wafer, selected angular regions can be positioned above the conduit end 34 so that the conduit captures radiation from the selected angular region, thus allowing the pyrometer 38 to measure the temperature of the selected angular region. In the bent conduit embodiment, any localized region can be positioned above the conduit end 34' by combining rotation of the wafer with rotation of the conduit, thus allowing the pyrometer 38 to measure the temperature of any desired localized region.

As the temperature profile of the wafer is being measured, the controller notes any deviations from the desired temperature profile. As deviations are noted, the controller controls the heating element 15 (via line 17) to adjust the intensity of the irradiating light 26 over the area where the deviation was noted. In this way, the temperature profile can be controlled and kept as close as possible to a desired profile.

The chamber temperature may cause changes in the physical properties of the upper surface 39 of the reflector 30; its reflectivity may fall well below the ideal value of 1 and its emissivity may increase substantially above 0. These changes would cause the behavior of the cavity 32 to deviate from the ideal cavity 10 of Fig. 1A (due to imperfect reflection and thermal emission by surface 39). To avoid these effects, reflector 30 is cooled to a temperature below that of the wafer. In the embodiment of Fig. 2, water cooling is used; the reflector 30 includes a coolant circulation conduit 33 which continually circulates coolant within the body of the reflector 30 to cool the reflector and the reflecting surface.

To prevent stray light 26 from the heating element 15 from entering the reflecting cavity 32, baffles 37 are located along the outer edges of the wafer 22. These baffles effectively prevent light 26 from entering the section of the processing chamber 21 below the wafer 22 and in particular reflecting cavity 32. If light 26 from the heating element 15 were to enter the reflecting cavity 32, because this light is not related to the thermal radiation from the wafer 22 and therefore not accounted for in equation (4), it might cause erroneous temperature measurements.

To minimize reflections, guard ring 24 has a color which absorbs the wavelengths of light 26 generated by the heating element 15, for example, black or grey. Baffles 37 may also have an absorbing color.

It is likely that at least some light 26 from the heating element 15 will reach the cavity 32. This light will be diffusely reflected within the cavity 32 and may enter the conduit 36 along with the thermal radiation from the wafer. The effect of this stray light 26 is greatest when the conduit is near to the edge of the wafer and minimized when the conduit is near to the center of the wafer; this is true because, on average, to reach the conduit at the center of the wafer, light 26 will have to reflect more times than if the conduit was located nearer to the edge of the wafer. At each reflection, part of the light 26 is absorbed, and as a result less light remains upon reaching the conduit.

Another way to prevent the light 26 which enters conduit 36 from affecting temperature measurements is to select a pyrometer 38 which determines temperature by sensing thermal radiation of wavelengths within a narrow band, and coat the underside of the quartz window 28 with an inert material which is transparent to thermal radiation in all but this narrow band of wavelengths, thereby preventing any components of light 26 which might affect temperature measurements from entering the processing chamber 21. Another similar approach uses a pyrometer which is sensitive to long wavelengths (e.g., greater than $4\mu m$) - at these wavelengths quartz is opaque and thus no light 26 in these wavelengths will enter the chamber (note, however, that this long-wavelength approach can only be used at temperatures above $700°$ C - as discussed below, at lower temperatures the wafer may be transparent to long wavelength light, leading to poor performance).

In the embodiment of Fig. 2, the reflector 30 is shown to be substantially parallel to the primary plane of the wafer 22. This configuration, however, represents only one embodiment and the reflector could be any shape which reflects thermal radiation from the wafer within the cavity, for example, a dish shape.

Furthermore, the surface of the body being measured need not be flat, as long as the topographies of the reflector and body operate to reflect thermal radiation isotropically within the cavity between the body and the reflector. Thus, for example, the surfaces of the body and reflector could have locally parallel, undulating topologies. Alternatively, reflector and body surfaces could be randomly located around the inner surface of the cavity, such as illustrated in Fig. 1B.

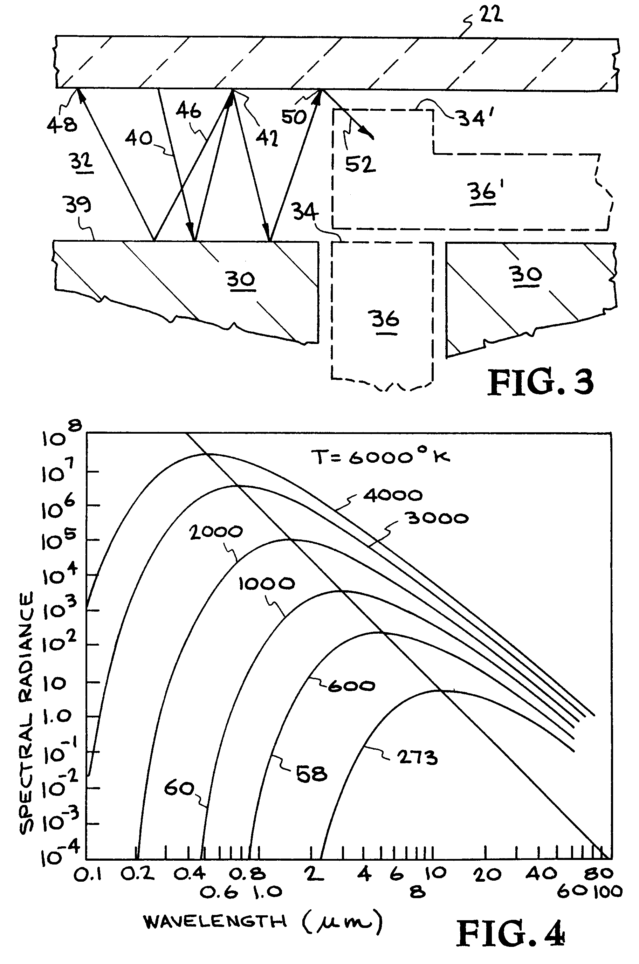

Fig. 3 illustrates cavity 32 in greater detail. In Fig. 3, only a portion of the wafer 22 and the reflector 30 are shown. Portions of the two embodiments of the conduit 36 and 36', and the open ends of the conduits 34 and 34' are also shown.

As has been previously indicated, the wafer 22 is heated during the processing thereof. Because the wafer 22 is hot, it emits thermal radiation from both its upper and its lower surfaces. Typically radiation leaving the lower surface of the wafer 22 is reflected between the reflecting surface 39 and the wafer 22 and undergoes a number of transformations along the way.

By way of example, the path of one ray of radiation is illustrated as a line 40 leaving the lower surface of the wafer 22. This radiation is then reflected from the reflecting surface 39 back towards the wafer 22. As the reflecting surface is a specular reflector with a reflectance of nearly 100%, essentially all of the radiation is reflected back, and the angle of reflection is equal to the angle of incidence. When the reflected radiation reaches the wafer surface 22 a certain amount of radiation is absorbed by the wafer 22 at point 42. The remainder of the radiation is diffusely reflected from the lower surface of the wafer as, for example, two different rays represented by lines 44 and 46. (The underside of a wafer is typically etched and therefore is a diffuse reflector for some wavelengths.) The ray 46 is, once again, reflected from reflecting surface 39 back onto the wafer 22 and is, for example, almost entirely absorbed by the wafer 22 at point 48. The light ray represented by line 44 is similarly reflected from the reflecting surface 39, but is only partially absorbed, at point 50, by the wafer 22 and the remainder of the radiation, represented by line 52, continues the repetitive process of reflection and absorption until it leaves the confines of the reflecting cavity 32.

Thus, the pattern of reflection and re-absorption of thermal emission in the geometry of Fig. 3 is similar to that of the ideal infinite parallel plates discussed above with reference to Fig. 1A, the differences being edge effects caused by radiation lost from the edge of the wafer and reflector. However, if the width of the reflector is substantially larger than the distance between the wafer and reflector, the number of reflections near the center of the reflector and wafer approach those found in the ideal geometry of Fig. 1A. Thus, near the center of the wafer the edge effects can be ignored, and in this area the radiation in the cavity 32 is substantially independent of the emissivity of the wafer.

The design requirements for the pyrometer 38 are best discussed by referring to the spectral radiance curves of a "black body", i.e., a body with emissivity $e = 1$, as shown in Fig. 4. Since the radiation in cavity 32 is the similar to the radiation of a black body, Fig. 4 also illustrates the relationship between spectral radiance and wavelength for radiation in cavity 32. Therefore this figure is useful in understanding the considerations involved in choosing a suitable pyrometer to measure the temperature of the wafer 22.

The pyrometer should sample wavelengths of thermal radiation at which the wafer 22 is not transparent. This is because the assumptions of the ideal model of Fig. 1A are that both the upper wall 11 and lower wall 12 have no transmittance and therefore that all thermal radiation generated by upper wall 11 in cavity 10 is either reflected within the cavity or reabsorbed by upper wall 11, and that no other radiation enters cavity 10. At the wavelengths at which wafer 22 is transparent, both of these assumptions fail and cavity 32 cannot be modelled by the ideal cavity 10 of Fig. 1A.

At room temperature, wafers are transparent to wavelengths of light longer than 1.1μm. As temperature increases, wafers become opaque to longer wavelengths until, at about 700° C, the wafer becomes opaque to all wavelengths of interest. Thus the choice of the sampling wavelength depends on the process temperature. If the process temperature will be substantially below 700° C, then the pyrometer must sample wavelengths shorter than 1.1μm. If higher process temperatures are used, then longer wavelengths can be sampled. (It should be noted that at very low process temperatures (e.g., 600° K (327° C), curve 58 of Fig. 4), only a small amount of the "black body" spectral radiance is at wavelengths shorter than 1.1μm. However, because typical wafers become transparent to long wavelengths at low temperatures, the pyrometer can only sample wavelengths shorter than 1.1μm. As a result, at temperatures below 600° K, it can be difficult to collect enough radiation to measure the temperature of typical wafers by the above method.)

One design, suitable for processes which operate at temperatures between 900° and 1350° C, uses a solid-state pyrometer 38 which is sensitive to radiation in the 0.9-1.0 μm range, for example a 900-LP-6.35C sensor combined with a 100-S8MS-B-8CV electronics box, both of which are available from Luxtron Corporation-Accufiber Division, at the address given above. As can be seen from Fig. 4, curve 60 (which shows radiation at 1000° K or 1273° C), in this temperature range there is substantial radiation between 0.9-1.0 μm, providing good signal strength and signal-to-noise ratio.

The above considerations depend on the material of the wafer and the operating temperature, and the choice of a suitable pyrometer will therefore also depend on these two factors.

The accuracy and repeatability of the temperature measurement system described above has been experimentally evaluated through the following procedure. Four groups of wafers were prepared, each having identically treated front sides but differently treated back sides. The first group had a standard "etched back" surface with no additional films. The second group had a polished back side with no additional films. The third group had an "etched back" side covered by 500 nm of thermal oxide. The fourth group had an "etched back" surface covered by 1000 nm of thermal oxide. Each of these backside surfaces has a substantially different emissivity ($e$) than the others since emissivity is a function of both the surface roughness and the thickness of the oxide film.

To evaluate a standard temperature measurement technique (pyrometry), the wafers were placed face down in the process chamber, so that the heating element irradiated the back side. The pyrometer also viewed the back side. To evaluate the temperature measurement technique disclosed above, the wafers were placed face-up in the chamber so that the heating element irradiated the front side while the temperature measurement was performed on the back side.

A rapid thermal oxide was grown on each wafer at approximately 1100° C for 60 seconds. A single conduit and pyrometer of the types described were used to measure temperature, and a feedback controller of the type described above was used to control the temperature to the desired value of 1100° C throughout the process. The resulting oxide thicknesses were then measured with an ellipsometer. The process repeatability was substantially improved using the new temperature measurement technique described above. The variation in the thickness of the grown oxide layer was reduced from 6.2 nm to 0.3 nm, as shown in the following table.

| Backside Surface | Oxide Thickness -Standard Method | Oxide Thickness -New Method |
|---|---|---|
| Etched | 10.8 nm | 11.0 nm |
| Polished | 12.8 nm | 10.8 nm |
| 500 nm Oxide | 7.6 nm | 11.1 nm |
| 1000 nm Oxide | 6.6 nm | 10.8 nm |

While the invention has been shown and described with reference to the measurement of the temperature of a semiconductor wafer, it will be understood by those skilled in the art that various alterations and modifications in form, detail and application of this invention may be made therein. Accordingly, it is intended that the following claims cover all such alterations and modifications as may fall within the true spirit and scope of the invention.

## Claims

1. Apparatus for measuring the temperature of a surface of a body, comprising:
   a reflector forming a reflecting cavity between said surface of said body and a reflecting face of said reflector, such that said reflecting face reflects thermal radiation emitted from said surface of said body back to said surface; and
   a radiation sensor sampling said thermal radiation and using the sampled radiation to determine the temperature of said body.

2. The apparatus of claim 1 wherein said reflecting face does not contact said surface of said body.

3. The apparatus of claim 1 wherein thermal radiation emitted from said surface is repeatedly reflected between said reflecting face and said surface of said body.

4. The apparatus of claim 1 wherein said reflecting face is cooled to a temperature substantially below the temperature of said body.

5. The apparatus of claim 1 wherein said reflecting face has a topography and said surface of said body has a topography, and said topographies are locally parallel.

6. The apparatus of claim 5 wherein said topographies are substantially flat.

7. The apparatus of claim 1 wherein the width of said reflecting face is at least twenty times larger than the largest distance between said reflecting face and said surface of said body.

8. The apparatus of claim 1 wherein said sensor comprises a light conductive conduit which collects thermal radiation from within said reflective cavity at a receiving end and carries collected thermal radiation to a remote measuring device.

9. The apparatus of claim 8 wherein said conduit penetrates said reflecting cavity through said reflecting face.

10. The apparatus of claim 8 wherein said conduit is coupled to an actuator which moves the receiving end of said conduit relative to said body.

11. The apparatus of claim 10 wherein said conduit is bent and said actuator moves the receiving end of said conduit by rotating said conduit.

12. The apparatus of claim 1 wherein said radiation sensor collects light from a location proximate said surface of said body.

13. The apparatus of claim 1 wherein said radiation sensor is adapted to sample radiation from different positions within the reflecting cavity.

**14.** An apparatus for measuring the temperature of a semiconductor wafer in a semiconductor wafer processing chamber, comprising:

a reflector placed within the chamber and facing the wafer so as to form a reflecting cavity between a surface of the wafer and a reflecting face of said reflector, such that said reflector reflects thermal radiation emitted from said surface of said wafer back to said surface; and

a radiation sensor sampling said thermal radiation and using the sampled radiation to determine the temperature of said wafer.

**15.** The apparatus of claim 14 wherein said reflector does not contact said surface of said wafer.

**16.** The apparatus of claim 14 wherein said thermal radiation is repeatedly reflected between said reflecting face and said surface of said wafer.

**17.** The apparatus of claim 14 wherein said reflecting face is cooled to a temperature substantially below the temperature of the wafer.

**18.** The apparatus of claim 14 wherein said reflecting face has a topography and said surface of said body has a topography, and said topographies are locally parallel.

**19.** The apparatus of claim 18 wherein said topographies are substantially flat.

**20.** The apparatus of claim 14 wherein said reflecting face does not contact said surface of said wafer, and the width of said reflecting face is at least twenty times larger than the largest distance between said reflecting face and said surface of said body.

**21.** The apparatus of claim 14 wherein said sensor comprises a light conductive conduit which collects thermal radiation from within said reflective cavity at a receiving end and carries collected thermal radiation to a remote measuring device.

**22.** The apparatus of claim 21 wherein said conduit penetrates said reflecting cavity through said reflecting face.

**23.** The apparatus of claim 21 wherein said conduit is coupled to an actuator which moves the receiving end of said conduit relative to said body.

**24.** The apparatus of claim 23 wherein said conduit is bent and said actuator moves the receiving end of said conduit by rotating said conduit.

**25.** The apparatus of claim 14 wherein said radiation sensor samples radiation from different positions on the wafer.

**26.** The apparatus of claim 14 further comprising:

a heating element for heating the semiconductor wafer, said heating element comprising a plurality of controllable radiant energy sources, each radiant energy source irradiating a portion of the surface area of the wafer; and

a controller for individually controlling the intensity of irradiation from at least one sub-group of said radiant energy sources, said controller being coupled to said radiation sensor so that the radiant energy sources are controlled in relation to the amount of thermal radiation sensed at different positions on the wafer by said sampling means.

**27.** The apparatus claim 26 further comprising baffles located about said wafer, said baffles limiting radiation from said radiant energy sources from passing into said reflecting cavity.

**28.** The apparatus of claim 14 wherein said radiation sensor comprises an objective lens.

**29.** The apparatus of claim 14 wherein said radiation sensor comprises a light conductive conduit located proximate to said surface of the wafer.

**30.** The apparatus of claim 29 wherein said light conductive conduit comprises an open tube with reflective internal surfaces.

**31.** The apparatus of claim 29 wherein said radiation sensor further comprises a pyrometer for measuring thermal radiation collected by said conduit.

**32.** The apparatus of claim 31 wherein said pyrometer is sensitive to a band of wavelengths at which said wafer is not transparent.

**33.** A method of measuring the temperature of a body from thermal radiation emitted from a surface of said body, comprising the steps of:

positioning a reflector to form a reflecting cavity between said surface and a reflecting face of said reflector, such that said reflecting face reflects thermal radiation emitted from said surface of said body back to said surface;

sampling thermal radiation within said reflecting cavity; and

determining the temperature of said body from sampled radiation.

**34.** The method of claim 33 further comprising cooling said reflecting face to a temperature substantially below the temperature of said body.

**35.** The method of claim 33 wherein said thermal radiation is sampled from a position proximate said surface of said body.

**36.** The method of claim 33 wherein said thermal radiation is sampled from a plurality of different positions within the reflecting cavity.

**37.** The method of claim 36 wherein said thermal radiation is sampled by scanning an area of said surface of said body.

**38.** The method of claim 33, further comprising the steps of:

heating said body; and

controlling said heating step in response to said determined temperature.

FIG.1A

FIG.1B

FIG. 2

EP 0 612 862 A1

FIG. 3

SPECTRAL RADIANCE

T = 6000°K

4000

3000

2000

1000

600

273

60

58

WAVELENGTH (μm)

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | PATENT ABSTRACTS OF JAPAN vol. 15, no. 300 (P-1232)30 July 1991 & JP-A-03 105 223 (MINOLTA CAMERA CO LTD) 2 May 1991 | 1,2,5,6, 14,15, 18,19,33 | C23C16/52 G01J5/00 |
| A | * abstract * | 3,4, 7-13,16, 17, 20-32, 34-38 | |
| X | PATENT ABSTRACTS OF JAPAN vol. 010, no. 215 (P-481)26 July 1986 & JP-A-61 054 417 (NEW JAPAN RADIO CO LTD) 18 March 1986 | 1-3,8,9, 33 | |
| A | * abstract * | 4-7, 10-32, 34-38 | |
| X | PATENT ABSTRACTS OF JAPAN vol. 010, no. 274 (P-498)18 September 1986 & JP-A-61 096 425 (KAWASAKI STEEL CORP) 15 May 1986 | 1-3,5,6, 33 | |
| | | | TECHNICAL FIELDS SEARCHED (Int.Cl.5) |
| A | * abstract * | 4,7-32, 34-38 | C23C G01J |
| X | SPIE PROCEEDINGS , RAPID THERMAL AND RELATED PROCESSING TECHNIQUES, SANTA CLARA, CA, USA, 2-3 OCT. 1990, 316 - 336 vol. 1393 , ISSN 0277-786X VANDENABEELE P ET AL 'Emissivity of silicon wafers during rapid thermal processing' | 1,2,5,6, 14,15, 18,19,33 | |
| A | * page 317, line 10 - line 22; figure 1 * | 3,4, 7-13,16, 17, 20-32, 34-38 | |

-/--

The present search report has been drawn up for all claims

| Place of search | Date of completion of the search | Examiner |
|---|---|---|
| THE HAGUE | 3 June 1994 | Ekhult, H |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | PATENT ABSTRACTS OF JAPAN<br>vol. 009, no. 113 (P-356)17 May 1985<br>& JP-A-60 001 529 (HITACHI SEISAKUSHO KK)<br>7 January 1985<br>* abstract * | 1-38 | |
| A | APPLIED OPTICS<br>vol. 20, no. 8 , 15 April 1981 , NEW YORK USA<br>pages 1389 - 1394<br>M. KOTLARCHYK ET AL 'CURVED TUBE CORRECTION FACTORS FOR INDIRECT MEASUREMENTS WITH A RADIATION THERMOMETER'<br>* page 1389, right column, line 1 - line 9 * | 1-38 | |
| A | PATENT ABSTRACTS OF JAPAN<br>vol. 13, no. 9 (P-811)11 January 1989<br>& JP-A-63 217 238 (NIKON CORP) 9 September 1988<br>* abstract * | 1-38 | TECHNICAL FIELDS SEARCHED (Int.Cl.5) |
| A | PATENT ABSTRACTS OF JAPAN<br>vol. 009, no. 232 (P-389)18 September 1985<br>& JP-A-60 086 431 (KAWASOU DENKI KOGYO KK;OTHERS: 01) 16 May 1985<br>* abstract * | 1-38 | |
| P,X | US-A-5 226 732 (BAKEMAN P E ET AL) 13 July 1993<br><br>* claim 1 * | 1-6,<br>14-19,<br>33,38 | |

The present search report has been drawn up for all claims

| Place of search | Date of completion of the search | Examiner |
|---|---|---|
| THE HAGUE | 3 June 1994 | Ekhult, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)